(19) **Europäisches Patentamt European Patent Office Office européen des brevets**

(11) **EP 1 351 428 B1**

(12) **FASCICULE DE BREVET EUROPEEN**

(45) Date de publication et mention
de la délivrance du brevet:
**14.11.2007 Bulletin 2007/46**

(51) Int Cl.:
*H04L 7/027* (2006.01)          *H03L 7/24* (2006.01)
*H03B 5/12* (2006.01)

(21) Numéro de dépôt: **03352007.3**

(22) Date de dépôt: **04.04.2003**

(54) **Procédé et dispositif de récupération d'horloge**

Verfahren und Vorrichtung zur Taktrückgewinnung

Method and device for clock recovery

(84) Etats contractants désignés:
**AT BE BG CH CY CZ DE DK EE ES FI FR GB GR HU IE IT LI LU MC NL PT RO SE SI SK TR**

(30) Priorité: **04.04.2002 FR 0204201**

(43) Date de publication de la demande:
**08.10.2003 Bulletin 2003/41**

(73) Titulaire: **CENTRE NATIONAL D'ETUDES SPATIALES (C.N.E.S.)
Etablissement public, scientifique et
F-75039 Paris Cédex 01 (FR)**

(72) Inventeurs:
 • **Scarabello, Christohe
  38500 Voiron (FR)**
 • **Deval, Yann
  33800 Bordeaux (FR)**
 • **Begueret, Jean-Baptiste
  33170 Gradignan (FR)**
 • **Fouillat, Pascal
  33610 Cestas (FR)**
 • **Le Gall, Jean-Yves
  31000 Toulouse (FR)**
 • **Pignol, Michel
  31000 Toulouse (FR)**

(74) Mandataire: **Cabinet BARRE LAFORGUE & associés
95, rue des Amidonniers
31000 Toulouse (FR)**

(56) Documents cités:
**US-A- 3 609 408          US-A- 3 904 988
US-B1- 6 256 361          US-B1- 6 317 008**

**Description**

L'invention concerne un procédé et un dispositif de transmission de données numériques sur une liaison série en bande de base selon une fréquence nominale fn supérieure à 500 MHz entre un émetteur et un récepteur reliés par un canal de transmission (câble (soit à un fil conducteur unique, soit à deux fils pour une liaison différentielle) ou fibre optique, ou radiofréquence monocanal...), du type dit "point-à-point".

Une telle transmission de données numériques par liaison série en bande de base peut être utilisée par exemple pour relier des ordinateurs (réseaux) ou autres dispositifs digitaux (télévision numérique, systèmes spatiaux...). Dans ces liaisons numériques série en bande de base, il est nécessaire, au niveau du récepteur, d'extraire du signal reçu, de nature analogique (signal électrique ou optique), d'une part les valeurs des données numériques transmises successivement par ce signal reçu et, d'autre part, le signal d'horloge correspondant à ces données. Le signal d'horloge utilisé dans le récepteur pour extraire les données doit être exactement synchronisé sur l'horloge de cadencement de ces données dans le signal reçu. Or, les horloges d'émission et de réception peuvent varier, notamment selon les tensions d'alimentation et la température, de sorte que cette synchronisation ne peut pas être obtenue par simple construction (choix d'horloges identiques). Le récepteur inclut donc nécessairement un dispositif d'extraction d'horloge, dit CR ("dock recovery").

Pour les liaisons série en bande de base à haut débit sur câble (supérieur à 500Mbit/s), comme pour les liaisons hyperfréquences en bande de base de type monocanal, on transmet ensemble sur un canal unique les informations « données » et « horloge ». Ceci permet d'éviter, pour ces fréquences, tout appairage délicat de la longueur des cheminements des signaux. Pour que le récepteur soit alors en mesure d'extraire l'information « horloge » à l'intérieur du signal reçu, ce dernier doit faire l'objet d'un codage.

L'émetteur transforme les données de N bits parallèles cadencées selon une fréquence mots, en un signal série en mots de M bits cadencé selon la fréquence bits grâce à une fonction de codage et de sérialisation. Si N = 8 ou 16 bits, usuellement on aura M = 10, 12 ou 20 bits.

Le récepteur effectue le traitement inverse. Il reçoit le signal série en mots de M bits qu'il transforme en données de N bits parallèles. Le dispositif d'extraction d'horloge extrait l'horloge bits de ces données. Un circuit de décision échantillonne le signal série reçu en le synchronisant avec la fréquence bits. La fréquence mots est déduite de la fréquence bits par un diviseur de fréquence. Les données parallèles sont régénérées grâce à un décodeur M bits/N bits et à une fonction de désérialisation.

Jusqu'à maintenant, la majorité des composants d'extraction d'horloge CR sont réalisés à partir d'une boucle à verrouillage de phase, dite PLL, qui comprend principalement, à la sortie d'un circuit générant des impulsions correspondant aux fronts montants et descendants du signal reçu, un comparateur de phase délivrant un signal de consigne à un oscillateur contrôlé en tension, dit VCO, via un filtre de boucle. Le VCO fournit un signal d'horloge interne à une bascule de décision permettant d'extraire les données du signal reçu.

La PLL est un système bouclé dans lequel la phase d'un signal est asservie à la phase d'un signal de référence. Ce système fonctionne sur les transitions du signal série entrant. Par conséquent, dans certaines réalisations, un circuit « générateur d'impulsions » est utilisé pour générer une impulsion de durée fixe à chaque transition (montante et descendante) du signal entrant ; la densité spectrale de puissance du signal ainsi obtenu contient donc une raie d'énergie non nulle à la fréquence de l'horloge bits, ce signal servant à alimenter la PLL.

Deux modes de fonctionnement sont distingués :

- lorsque les deux signaux (horloge et données) ne sont pas en phase, le comparateur de phase génère une tension d'erreur ; cette tension est filtrée par le filtre de boucle et sa valeur moyenne pilote directement le VCO,
- lorsque la bouche est verrouillée, les deux signaux sont en phase et aucune tension d'erreur n'est générée.

Il existe de nombreux types de comparateurs de phase mais les plus utilisés sont des détecteurs de phase/fréquence. En effet, ils facilitent le verrouillage de la PLL grâce à leur sensibilité aux différences des signaux d'entrée. Ils sont associés à une pompe de charge, ce qui permet une plage de capture couvrant toute la plage de variation du VCO et en théorie une erreur statique nulle lorsque la boucle est verrouillée.

Le filtre de boucle extrait la valeur moyenne de la tension d'erreur du comparateur de phase. Il s'agit d'un filtre passe bas. Il peut être passif ou actif.

Le VCO doit répondre à un cahier des charges très contraignant en terme de bruit de phase et de plage de variation de fréquence. Il existe deux grandes familles de VCO :

- les oscillateurs à relaxation tels que les astables ou les oscillateurs en anneau,
- les oscillateurs à réseau LC ; il s'agit des oscillateurs harmoniques, des oscillateurs à résistance négative ou bien des oscillateurs à déphasage.

Une PLL réalise ainsi une adaptation permanente de la phase du signal d'horloge interne à la phase du signal reçu en modifiant légèrement la fréquence pour rattraper le décalage de phase éventuel.

Dans le cas de transmission de données comportant une longue série de bits identiques successifs (donc sans transition), aucune tension d'erreur ne serait alors disponible et, par conséquent, le VCO dériverait jusqu'à revenir à sa fréquence de repos, rompant l'asservissement. Pour éviter cette perte de synchronisation, il est nécessaire de coder les données pour que le signal reçu par le récepteur contienne une densité suffisante de transitions.

Ces circuits PLL représentent la solution la plus classique, utilisée depuis de nombreuses années, pour la réalisation de la fonction d'extraction d'horloge CR. Ils présentent tous une consommation importante. En effet, même dans les modes de réalisation les plus simples, il faut au minimum un oscillateur ayant des contraintes sur le bruit de phase et sur sa plage de fonctionnement, un filtre de boucle dont dépendent les propriétés de la PLL en terme de rapidité et de bruit de phase, un comparateur de phase et un détecteur de fronts fonctionnant à la fréquence bits. En outre, les éléments de certains filtres ou oscillateurs, tels que les oscillateurs à quartz ne peuvent pas être entièrement intégrés, ou alors l'intégration totale du circuit se fait au détriment de la taille du circuit.

Par ailleurs, ils présentent des limites de fonctionnement notamment en terme de fréquence. Ainsi, la mise au point de circuits PLL compatibles avec des liaisons à haut débit (horloge à haute fréquence supérieure à 500MHz) est un souci permanent de la recherche dans ce domaine (cf. par exemple "A 0.155, 0.622-, and 2.488-Gb/s Automatic Bit-Rate Selecting dock and Data Recovery IC for Bit-Rate Transparent SDH Systems" C. Scheytt et al, IEEE Journal of Solid State Circuits, Vol 34, N° 12, December 1999 ; "Differential CMOS circuits for 622- MHz/933-MHz Clock and Data Recovery Applications" H. Djahanshahi et al, IEEE Journal of Solid State Circuits, Vol. 35, N°6, June 2000...). Néanmoins, avec les fréquences actuellement envisagées pour la transmission de données, toujours plus élevées (plusieurs gigahertz pour les applications industrielles ; plus de 10 gigahertz pour les applications de laboratoire), et malgré une recherche permanente en ce sens, les circuits à base de PLL ne permettent d'obtenir une fonction CR qu'avec des solutions technologiques complexes et coûteuses du point de vue tant de leur réalisation que de leur consommation énergétique et qui, le plus souvent, présentent des performances pratiques relativement faibles (taux d'erreurs de bits relativement élevé).

Parmi les autres solutions envisagées pour réaliser une fonction CR, on peut citer la boucle de verrouillage de délai, dite DLL, mise au point en 1990, qui présente l'avantage de pouvoir être réalisée en technologie monolithique numérique. Néanmoins, ces circuits DLL offrent des performances relativement faibles en termes de "jitter", c'est-à-dire de bruits ou décalages de phase intempestifs. Ainsi, la publication "A 155MHz Clock Recovery Delay-and Phase-Locked Loop" T.H. Lee et al, IEEE Journal of Solid State Circuits, Vol. 27, n° 12, December 1992, suggère de combiner des DLL et des PLL pour remédier au problème des "jitter". En outre, les circuits DLL consomment aussi beaucoup d'énergie et nécessitent un nombre de transistors important.

Egalement, certains auteurs ont proposé d'utiliser un oscillateur optoélectronique, appelé OEO (par exemple « A High-Speed Photonic dock and Carrier Regenerator » X.5. Yao, G. Lutes, TDA Progress report, May 15, 1995 pp 202-210). Un tel oscillateur est composé d'un laser de pompe et d'un circuit de contre-réaction faisant appel à différents éléments. Une synchronisation sur un tel oscillateur optique entraîne des problèmes autant au point de vue de la réalisation des circuits qui ne peuvent pas être des circuits VLSI et nécessitent une cavité résonnante, qu'au point de vue de la consommation.

Par ailleurs, le document US-6 256 361 décrit un circuit récupérateur d'horloge conçu pour fonctionner à des fréquences relativement faibles (expérimenté à 155, 520 MHz et 184, 320 MHz). Le circuit décrit est analogique. Le circuit comprend un générateur d'impulsions dont la structure n'est pas précisée, et un oscillateur verrouillé en injection de type Colpitts, nécessitant un réglage manuel de fréquence par une inductance variable à haute performance L1. Un tel circuit ne peut pas faire l'objet d'une réalisation compatible avec des fréquences supérieures à 500 MHz et nécessite un réglage préalable précis de l'inductance variable L1 pour permettre l'accrochage en fréquence. Il est donc extrêmement délicat dans sa mise en oeuvre, ce qui en limite considérablement les applications. En particulier, il n'est pas compatible avec une technologie monolithique ni avec une intégration dans un système spatial dans lequel aucun réglage n'est permis après le lancement, notamment pour prendre en compte une éventuelle dérive des composants électroniques.

La publication GABARA T. XP010340781 décrit aussi un circuit de récupération d'horloge comprenant un oscillateur CMOS LC verrouillé en injection compatible avec des fréquences de 1 à 5 GHz. Cet oscillateur reçoit le train de données NRZ via une impédance. Aucun générateur d'impulsions n'est prévu. Le fonctionnement de ce montage se fonde donc sur un défaut du signal NRZ, à savoir la présence d'une raie résiduelle à la cadence de bit due à une dissymétrie rencontrée dans la plupart des signaux NRZ réels. Ainsi, si le signal NRZ est parfait, le montage est inopérant. Par ailleurs, là-encore, un contrôle par une tension continue doit être prévu pour ajuster précisément la fréquence de l'oscillateur à celle des données série à l'entrée. Néanmoins, la moindre dérive en température ou en tension, inévitable dans le cadre d'une application industrielle, entraîne un décrochage du circuit.

US 6,317,008 décrit un circuit de récupération d'horloge comprenant un oscillateur à injection dont la fréquence propre doit être ajustée dans la plage de verrouillage de la fréquence du signal fourni à l'entrée de cet oscillateur, à l'aide d'un contrôle de la tension continue appliquée à cet oscillateur.

Dans ce contexte, l'invention vise à proposer un procédé et un dispositif de transmission synchronisée de données numériques en série en bande de base qui soient compatibles avec des fréquences nominales supérieures à 500 MHz -notamment supérieures à 1 GHz et pouvant aller au-delà de 10 GHz- en assurant spontanément un accrochage en fréquence sans nécessiter d'ajustement préalable précis de la fréquence nominale de l'oscillateur ; qui présentent un taux d'erreurs de bits suffisamment faible pour être compatible avec les applications envisagées ; qui puissent faire l'objet d'une réalisation sur circuit intégré monolithique numérique notamment du type VLSI ; qui soient de conception simple et fiable, économique à la réalisation et de faible consommation énergétique ; et qui puissent être mis en oeuvre dans de nombreuses applications pour des liaisons numériques série en bande de base.

Plus particulièrement, l'invention vise à proposer un tel procédé et un tel dispositif avantageusement adaptés aux applications aéronautiques ou spatiales, pour la réalisation des systèmes embarqués à bord d'engins aéronautiques ou spatiaux, pour lesquels les contraintes de poids, de volume, de consommation énergétique, de fiabilité et de durée de vie sont prépondérantes.

Pour ce faire, l'invention concerne un procédé conforme à la revendication 1.

L'invention s'étend à un dispositif conforme à la revendication 11.

Il est à noter que les oscillateurs à injection sont connus depuis longtemps. Un oscillateur à injection est un oscillateur de fréquence propre fos, mais qui, lorsqu'il est alimenté par un signal périodique de fréquence fd, se synchronise sur cette fréquence fd en fournissant un signal de sortie à cette fréquence fd, à condition que fd soit suffisamment proche de fos. On sait aussi que les oscillateurs à injection peuvent être utilisés pour réaliser la récupération de porteuse et/ou d'horloge, à la place des PLL, dans les communications hertziennes modulées ou les réseaux WLAN (boucle locale sans fil) ou UMTS (téléphone mobile de 3ème génération) où la transmission des informations se fait en superposant l'information que l'on souhaite transmettre sur une onde support : la porteuse. Les modulations les plus connues sont :

- la modulation d'amplitude (AM) qui consiste à coder l'information par des variations d'amplitude de l'onde porteuse,
- la modulation de fréquence (FM) qui consiste à coder l'information par des variations de la fréquence de l'onde porteuse,
- la modulation de phase (PSK) qui consiste à coder l'information par des sauts de phase de l'onde porteuse.

L'ensemble onde porteuse et signal utile est appelé « onde modulée ». Les réseaux WLAN et UMTS fonctionnent sur plusieurs autres types de modulation plus complexes, notamment l'étalement de spectre par saut de fréquence (FHSS).

Dans une transmission par modulation telle que la modulation par déplacement de phase (QPSK), la logique séquentielle de reconstruction permet de retrouver les données (ou le signal modulant). Les données contenues dans l'onde modulée n'ont pas besoin de mise en forme (ou codage) particulière puisque l'information sur l'horloge est contenue dans la fréquence de la porteuse et dans le rapport horloge mots/largeur de la bande du canal. Connaissant la fréquence de la porteuse et la bande passante, l'horloge mots peut être récupérée. Donc, dans l'absolu, une réception d'un signal ne contenant que des '0' ou que des '1' est théoriquement possible puisque l'horloge n'est pas contenue dans les données.

Dans ces transmissions par modulation, le signal transmis est donc toujours périodique (fréquence de porteuse), et le problème à la base de la présente invention ne se pose donc pas. Les enseignements relatifs aux oscillateurs à injection utilisés dans les transmissions modulées ne sont donc pas transposables pour les liaisons série en bande de base où les problèmes de synchronisation à haut débit sont beaucoup plus complexes.

En particulier, rien ne permettait de prévoir le résultat surprenant de l'invention selon lequel un oscillateur à injection pourrait être utilisé avec un signal d'entrée non périodique en le couplant à un générateur d'impulsions tel que mentionné ci-dessus. Egalement, rien ne pouvait laisser penser qu'un réglage fin de la fréquence nominale de l'oscillateur n'est en pratique pas nécessaire, le circuit assurant spontanément un accrochage en fréquence sur une large plage.

En outre, il faut noter que les oscillateurs à injection ont été envisagés dans les communications modulées pour la récupération de porteuse ou d'horloge essentiellement en technologie bipolaire et dans des domaines de fréquences inférieures à 100 MHz, où les solutions telles que les PLL traditionnelles donnent en fait satisfaction. Rien ne permettait donc de penser qu'un simple oscillateur à injection réalisé dans un circuit intégré monolithique, et bien qu'il soit alimenté par un signal non périodique, peut en fait, combiné à un codage approprié du signal émis, fournir une réelle solution dans le domaine des liaisons série en bande de base (sans modulation) à haut débit (supérieur à 500 Mbits/s).

Dans un dispositif selon l'invention, le circuit de récupération d'horloge formé du générateur d'impulsions et de l'oscillateur à injection, comprend un faible nombre de composants, soumis à des conditions de fonctionnement peu contraignantes (moins contraignantes que pour les composants d'une PLL) et pouvant être aisément intégrés dans un circuit intégré monolithique de fabrication relativement simple (plus simple qu'une PLL), fiable et économique. Le faible nombre de composants fonctionnant au rythme des données entraîne une faible consommation énergétique. La simplicité et le faible nombre de composants permet un fonctionnement aux fréquences élevées. Il est à noter à cet égard qu'il se trouve que la réalisation de l'oscillateur sous forme de circuit intégré monolithique selon les technologies courantes, induit en fait par construction l'obtention d'une fréquence élevée de résonance de l'oscillateur à injection, notamment supérieure à 500MHz.

Avantageusement et selon l'invention, le circuit de récupération d'horloge est formé sur un circuit intégré monolithique incorporant le générateur d'impulsions et l'oscillateur à injection.

Du fait de l'absence de boucle, de filtre de boucle et de commande d'erreur, le temps d'accrochage de l'oscillateur à injection est fortement réduit par rapport à celui d'une PLL, et est en fait quasi-instantané.

La fréquence propre d'oscillation fos libre de l'oscillateur à injection peut ne pas correspondre exactement à la fréquence d'horloge bits fsr du signal reçu. Néanmoins, chaque impulsion du signal d'impulsions, synchronisée avec l'horloge bits, bien que formant un signal non périodique, permet en fait de recaler régulièrement l'oscillateur à injection sur la fréquence d'horloge bits fsr.

Avantageusement et selon l'invention, le générateur d'impulsions et l'oscillateur à injection sont adaptés pour que la largeur des impulsions en courant délivrées par le générateur d'impulsions, soit de l'ordre de la moitié de la période correspondant à la fréquence propre fos de l'oscillateur à injection.

Avantageusement et selon l'invention, le générateur d'impulsions et l'oscillateur à injection sont adaptés pour que la largeur des impulsions en courant délivrées par le générateur d'impulsions, soit inférieure à la moitié de la période correspondant à la fréquence propre fos de l'oscillateur à injection. De préférence, la largeur des impulsions est légèrement inférieure à la moitié de la période de la fréquence propre fos. On obtient ainsi une plage de synchronisation optimale.

Le signal reçu étant un signal série représentatif de données numériques est théoriquement formé de créneaux (bien qu'en pratique il s'agisse plutôt de courbes) et présente des fronts (c'est-à-dire des transitions plus ou moins rapides) montants et des fronts descendants. Avantageusement et selon l'invention, le générateur d'impulsions est adapté pour fournir à l'oscillateur à injection un signal d'impulsions représentatif d'une seule catégorie de fronts choisie parmi la catégorie des fronts montants et la catégorie des fronts descendants, et synchronisé avec cette catégorie de fronts du signal reçu. On a en effet constaté, avec surprise, que malgré le fait que l'utilisation de l'une seulement des catégories de fronts (soit les fronts montants, soit les fronts descendants) entraîne une resynchronisation deux fois moins fréquente de l'oscillateur sur la fréquence de bits du signal reçu, en réalité cette resynchronisation s'effectue correctement et avec beaucoup moins de bruit en sortie que lorsqu'on utilise tous les fronts du signal. Une des explications de ce résultat surprenant pourrait tenir dans le fait que les fronts montants ne seraient pas en pratique strictement en phase avec les fronts descendants (dissymétrie des temps de propagation entre le passage de « 0 » à « 1 » et le passage de « 1 » à « 0 »).

L'oscillateur à injection est un oscillateur synchrone qui comprend deux transistors à effet de champ couplés selon une topologie différentielle. Avantageusement et selon l'invention, l'oscillateur à injection comprend deux branches symétriques en parallèle comprenant chacune un transistor à effet de champ, une inductance série et une capacité parallèle. Avantageusement et selon l'invention, dans chaque branche l'inductance est reliée au transistor par le noeud d'entrée/sortie relié à une source de courant du générateur d'impulsions. Avantageusement et selon l'invention, les transistors à effet de champ sont du type MOS. Avantageusement et selon l'invention, les deux branches sont alimentées par une source de tension commune reliée à chaque inductance, et par une source de courant commune reliée entre des premières bornes (notamment les sources) des transistors et le potentiel le plus faible (masse), l'inductance et la capacité de chaque branche étant reliées à une deuxième borne (notamment le drain) du transistor aussi reliée à la grille du transistor de l'autre branche. L'oscillateur à injection présente ainsi une topologie différentielle, symétrique par rapport à la masse minimisant les couplages des substrats. En outre, cette structure présente un rapport plage de synchronisation/amplitude du courant synchronisant qui est élevé, et favorise donc la synchronisation. Elle peut être aisément réalisée sur un circuit intégré en technologie monolithique avec une fréquence propre fos d'oscillation élevée.

Selon l'invention, le générateur d'impulsions comprend deux sources de courant en parallèle adaptées pour délivrer des signaux de même amplitude, de même fréquence mais en opposition de phase. Ainsi, le générateur d'impulsions présente aussi une structure différentielle.

Le récepteur comprend un circuit de décision délivrant les données numériques série à partir du signal reçu et du signal d'horloge de réception extrait un signal reçu par le circuit de récupération d'horloge. Ce circuit de décision peut être formé d'une simple bascule D. En variante, avantageusement et selon l'invention, le récepteur comprend un circuit de décision recevant le signal d'horloge de réception et le signal reçu, et comprenant un nombre au moins égal à 3 -notamment impair-, de bascules D fournissant des données décalées selon des durées de décalage distinctes par rapport aux impulsions du signal d'horloge de réception mais normalement incluses dans la période de la fréquence nominale fn du signal d'horloge de réception. Une logique de décision forme un signal de sortie du circuit de décision correspondant à la valeur de sortie donnée en majorité par ces bascules jusqu'au front subséquent du signal d'horloge de réception. De la sorte, on garantit que les signaux de données série restitués sont bien calés en phase sur le signal reçu, et ce, même en présence d'impulsions parasites dans le signal reçu. Cette logique de décision diminue donc le taux d'erreurs de bits.

On utilise par exemple trois bascules dont l'une est décalée d'une demi-période de la fréquence nominale fn par rapport au front de l'horloge bits restituée, et les deux autres sont décalées de part et d'autre de celle-ci par exemple de l'ordre de 1/4 de période et de 3/4 de période de la fréquence nominale fn. Par ailleurs, l'utilisation de plusieurs bascules décalées en phase permet de détecter la présence d'une dérive de phase dans un sens ou dans l'autre. Cette information de détection peut être fournie au système qui pourra réagir de façon appropriée, notamment en cas de données critiques (par exemple données de contrôle d'un système spatial) en demandant une resynchronisation de la ligne et/ou une retransmission des données.

Le codage utilisé pour le signal émis (et donc aussi pour le signal reçu) est adapté pour que le taux de transitions soit suffisant pour assurer une resynchronisation suffisamment fréquente de l'oscillateur à injection en évitant toute erreur de bit. En pratique, le taux de transitions à respecter dépend de la différence existant réellement entre la fréquence nominale fn et la fréquence propre fos de l'oscillateur. On a ainsi constaté avec surprise qu'il suffit que le taux de transitions soit suffisamment important pour que l'oscillateur à injection fournisse un signal périodique synchronisé, alors même qu'il reçoit un signal non périodique.

Ce taux de transition optimum peut être ajusté expérimentalement (selon les applications envisagées, notamment selon le taux d'erreurs considéré comme acceptable...). Le codage utilisé permettant d'assurer le taux de transition peut être choisi parmi divers codages connus en eux-mêmes et présentant cette propriété, notamment l'un des codages suivants : codage brouilleur ; codage 8B/10B « Fibrechannel » ; 8B/12B « Start/stop »...

L'invention concerne aussi un procédé et un dispositif caractérisés en combinaison par tout ou partie des caractéristiques mentionnées ci-dessus ou ci-après.

D'autres buts, caractéristiques et avantages de l'invention apparaissent à la lecture de la description suivante d'un de ses modes de réalisation donné uniquement à titre d'exemple non limitatif, et qui se réfère aux figures annexées dans lesquelles :

- la figure 1 est un schéma synoptique général d'une liaison série en bande de base,
- la figure 2 est un schéma synoptique fonctionnel d'un récepteur d'une liaison série en bande de base,
- la figure 3 est un schéma synoptique fonctionnel d'une partie d'un réception d'une liaison série en bande de base conforme à l'invention,
- la figure 4 est un schéma d'un mode de réalisation d'un circuit de récupération d'horloge d'un récepteur d'un dispositif selon l'invention,
- la figure 5 est un exemple de chronogramme de signaux aux points A, B, C du générateur d'impulsions de la figure 4,
- la figure 6 est un schéma d'un mode de réalisation d'un circuit de décision d'un récepteur d'un dispositif selon l'invention,
- les figures 7a, 7b, 7c sont des chronogrammes de signaux fournis par les différentes bascules du circuit de décision, respectivement dans trois situations possibles différentes.

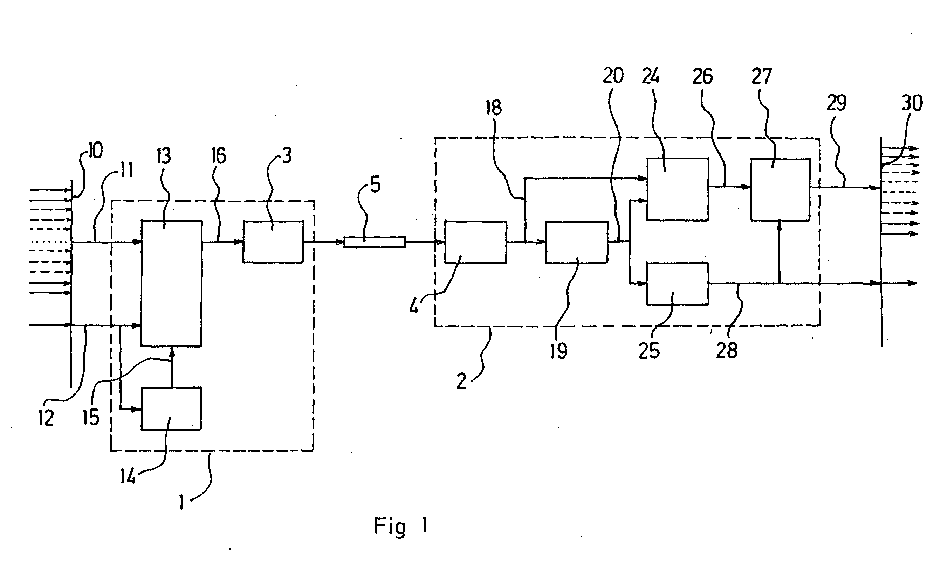

Sur la figure 1, on a représenté les principales fonctions permettant de réaliser une transmission de données numériques sur une liaison série en bande de base selon une fréquence nominale fn souhaitée supérieure à 500MHz entre un émetteur 1 et un récepteur 2 reliés par un canal de transmission 5 unique, de type point à point. Les données numériques 10 à transmettre doivent être émises par l'émetteur 1 sur le canal 5, puis reçues par le récepteur 2 qui génère des données numériques 30 correspondant aux données numériques 10 émises. Sur ce canal de transmission 5, les données sont véhiculées sous forme d'un signal analogique comprenant des fronts (transitions) montants et descendants et représentant ces données sous forme codée et en série. Le canal de transmission 5 unique peut être formé d'un fil conducteur électrique unique ou d'une fibre optique unique ou d'une liaison radio fréquence monocanal (signal non différentiel). En variante, et dans les exemples représentés et décrits ci-après, le signal peut être transmis en différentiel, et le canal de transmission 5 comprend alors deux lignes (deux fils conducteurs électriques ou deux fibres optiques) transmettant deux composantes en opposition de phase du même signal.

Les données numériques 10 à transmettre comprennent des données parallèles sous forme de N bits, N étant un entier quelconque pouvant être par exemple égal à 8, 16, 32... fournis sur un bus parallèle 11, et un signal d'horloge 12 déterminant la fréquence, dite fréquence mots, de présentation des mots de données parallèles . Les données parallèles sont fournies à un circuit 13 de codage et de sérialisation qui délivre un signal de données série à deux composantes DATA et DATA en opposition de phase. L'horloge mots 12 est fournie à un circuit multiplicateur de fréquences 14 qui délivre un signal d'horloge 15 à la fréquence, dite fréquence bits, correspondant à la fréquence nominale fn de transmission 15 bits de données sur le canal 5. Ce signal d'horloge bits 15 est fourni au circuit 13 de codage et de sérialisation. Ce circuit 13 fournit donc des données numériques en série sur une ligne série 16 à un amplificateur de transmission 3 dont la sortie alimente le canal de transmission 5 avec un signal série en bande de base, dit signal émis, à deux composantes en opposition de phase, représentatif des données numériques et cadencé selon la fréquence d'horloge bits correspondant à la fréquence nominale fn de fonctionnement de la transmission. Le circuit 14 multiplicateur de fréquences de l'émetteur 1 comprend une horloge interne d'émission de fréquence fe correspondant à la fréquence nominale fn mais qui n'est pas strictement identique à cette fréquence nominale fn théorique souhaitée.

En fait, le signal émis sur le canal de transmission 5 par l'amplificateur 3 est cadencé selon la fréquence d'horloge bits déterminée par la fréquence fe d'horloge interne de l'émetteur 1.

Le récepteur 2 comprend un amplificateur de réception 4 recevant le signal série en bande de base, dit signal reçu (deux composantes en opposition de phase), du canal de transmission 5, et fournit le signal série amplifié 18 correspondant DATA IN et DATA IN, d'une part à un circuit de récupération d'horloge 19, et d'autre part, à un circuit de décision 24 permettant de restituer les données numériques DATA OUT et DATA OUT sur une liaison numérique série 26. Le circuit de récupération d'horloge 19 délivre un signal 20 d'horloge de réception CLOCK et CLOCK en opposition de phase, au moins sensiblement synchronisé et en phase avec la fréquence d'horloge bits fsr du signal reçu. A partir de ce signal d'horloge de réception CLOCK, CLOCK et du signal reçu amplifié DATA IN et DATAIN, le circuit de décision 24 est capable de fournir un signal numérique DATA OUT, DATA OUT, comprenant des bits en série au moins sensiblement synchronisés et en phase avec le signal reçu. Ce signal numérique série 26 est fourni à un circuit 27 de décodage et de mise en parallèle adapté pour délivrer des données sur un bus parallèle 29. Le signal d'horloge de réception 20 est fourni à un circuit diviseur de fréquences 27 qui délivre une horloge 28 à la fréquence mots, qui d'une part est délivrée au circuit de décodage et de mise en parallèle 27, et, d'autre part, est incorporée aux données parallèles 29 pour former, avec elles, les données 30 numériques parallèles reçues générées par le récepteur 2.

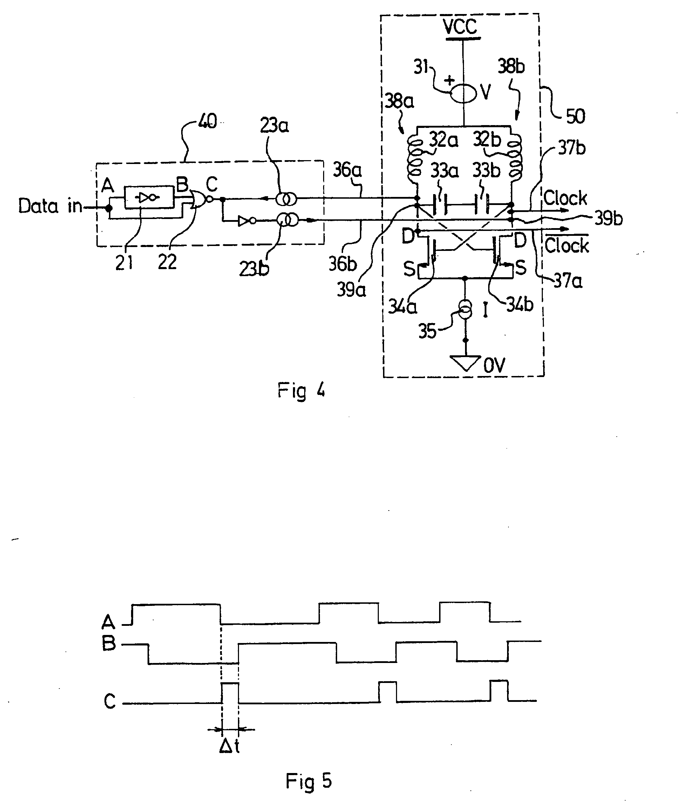

La figure 4 représente un mode de réalisation préférentiel d'un circuit de récupération d'horloge 19 conforme à l'invention, qui comprend un circuit générateur d'impulsions 40 et un oscillateur à injection ou oscillateur synchrone 50.

L'oscillateur à injection 50 est un circuit résonnant formant un dipôle recevant un signal par les lignes d'entrée 36a, 36b à deux composantes et délivrant en sortie un signal d'horloge à deux composantes CLOCK, CLOCK sur les lignes de sortie 37a, 37b. En l'absence de données, l'oscillateur à injection 50 a une fréquence propre fos. Si un signal constitué d'impulsions de synchronisation est envoyé à une fréquence fsr aux lignes d'entrées 36a, 36b, et si cette fréquence fsr est suffisamment proche de fos, alors l'oscillateur à injection 50 se met quasi-instantanément à osciller à la fréquence fsr et fournit le signal d'horloge à cette fréquence. Cet oscillateur à injection 50 a donc la faculté de se verrouiller sur un signal extérieur ou ses sous-harmoniques à la condition que la fréquence fsr soit dans sa plage de fonctionnement, dite aussi plage de capture. Après chaque impulsion de synchronisation, l'oscillateur à injection 50 dérive lentement vers sa fréquence propre fos jusqu'à la prochaine impulsion de synchronisation.

La synchronisation différentielle sur le rythme des données entrantes nécessite la réalisation d'un générateur d'impulsions 40 relié aux bornes des capacités du circuit résonnant de l'oscillateur à injection 50.

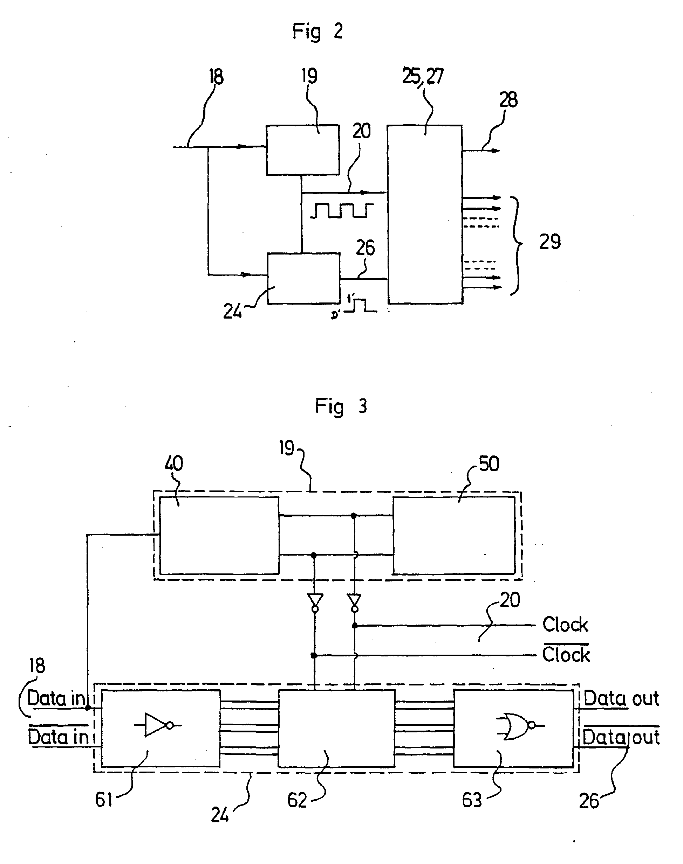

Le principe du générateur d'impulsions 40 consiste à utiliser exclusivement les fronts montants (ou exclusivement les fronts descendants) du signal reçu amplifié 18 DATA IN pour réaliser les impulsions nécessaires à la synchronisation de l'oscillateur à injection 50 (non représenté). Il est possible de n'utiliser qu'une seule des composantes DATA IN (figure 3) ou DATAIN du signal reçu 18 pour alimenter le circuit de récupération d'horloge 19.

Le codage utilisé à l'émission pour la liaison numérique doit être adapté aux caractéristiques de l'oscillateur à injection 50. En effet, si les données séries comportent des mots contenant trop de bits identiques successifs, l'oscillateur à injection 50 risque de ne plus être asservi et de se remettre à osciller à sa fréquence propre. Le taux de transitions de bits doit donc être adapté en conséquence. Il peut être déterminé expérimentalement selon la différence entre la fréquence propre fos de l'oscillateur 50 et la fréquence bits fsr du signal reçu, et en fonction du taux d'erreurs de bits considéré comme acceptable. Avant fabrication, on peut estimer le taux de transitions minimum par simulation, en déterminant la valeur la plus défavorable pouvant être obtenue pour la fréquence fos de l'oscillateur 50. Et on pourra éventuellement après fabrication du circuit affiner ce taux de transitions minimum selon la valeur réelle obtenue pour fos et le taux d'erreurs de bits considéré comme acceptable.

On peut utiliser tout type de codage qui assure un taux minimum de transitions, par exemple: brouilleur, 8B/10B « Fibrechannel »; 8B/12B « Start/stop », etc..

L'oscillateur à injection 50 représenté est un oscillateur à résistance négative utilisant une paire couplée de transistors MOS 34a, 34b.

Le circuit de l'oscillateur à injection 50 comprend :

- une source de tension 31 reliée à l'alimentation positive Vcc du circuit,
- une source de courant 35 dont la sortie est au potentiel le plus faible (0 volt ou masse),
- entre la source de tension 31 et la source de courant 35, deux branches identiques 38a, 38b en parallèle comprenant chacune en série une inductance 32a, 32b et un transistor 34a, 34b qui, dans l'exemple représenté, est un NMOS. Dans chaque branche, l'inductance 32a, 32b est interposée entre la source de tension 31 et le drain D du transistor 34a, 34b auquel elle est reliée par un noeud 39a, 39b. La source S du transistor 34a, 34b est reliée à la source de courant 35. La grille G du transistor 34a, 34b d'une branche 38a, 38b est reliée au noeud 39b, 39a, c'est-à-dire au drain du transistor 34b, 34a de l'autre branche 38b, 38a. Bien sûr, d'autres montages respectant les polarités des transistors sont possibles, selon le type de transistor utilisé.

Les noeuds 39a, 39b des deux branches 38a, 38b sont reliés par deux capacités identiques 33a, 33b montées en série l'une par rapport à l'autre, mais en parallèle entre les noeuds 39a, 39b par rapport aux branches 38a, 38b. Les noeuds 39a, 39b forment les entrées/sorties de l'oscillateur 50, respectivement pour chaque composante du signal. Chaque noeud 39a, 39b est à la jonction de l'inductance 32a, 32b, de la capacité 33a, 33b et du transistor 34a, 34b.

Le générateur d'impulsions 40 présente deux sources de courant 23a, 23b reliées respectivement aux noeuds 39a, 39b des deux branches 38a, 38b.

Cette structure présente deux avantages : d'une part, sa topologie est différentielle, ce qui est un atout au regard des couplages substrats puisqu'il est symétrique par rapport à la masse, d'autre part, cette structure est très favorable à la synchronisation, car son rapport (plage de synchronisation)/(amplitude du courant synchronisant) est très grand comparé aux oscillateurs de type Colpitts ou Hartley.

Par exemple, pour une liaison numérique devant fonctionner à un débit de 1 Gbit/s, l'oscillateur à injection 50 doit présenter une fréquence d'oscillation propre fos la plus proche possible de 1 GHz.

La théorie donne une pulsation d'oscillation libre ωos :

$$\omega os = \sqrt{\frac{1 + (2\,gl - gm)\,r}{L.(C' + C'')}} \qquad [1]$$

Telle que:

C'=C+2Cgd
C" = Cgs + Cgb + Cdb + Cox1 + Cint

Cgd, Cgs, Cgb, Cdb représentent respectivement les capacités grille-drain, grille-source, grille-substrat et drain-substrat d'un transistor 34a, 34b, gm représente la transconductance des transistors 34a, 34b, gl la charge de l'oscillateur, r, Cox1 et Cint sont les paramètres internes du modèle de chaque inductance 32a, 32b.

La source de tension 31 permet de centrer la valeur moyenne des signaux oscillants sur 1,25V (Vcc/2). Ainsi, les deux sources de courant 23a, 23b du générateur d'impulsions 40 sont polarisées de façon identique. La source de courant 35 de l'oscillateur 50 permet d'obtenir la polarisation désirée pour le fonctionnement de l'oscillateur 50. Chaque inductance 32a, 32b, calibrée pour un fonctionnement à 1GHz a par exemple une valeur de 5,6 nH.

Pour respecter la symétrie par rapport à la masse, il est prévu deux capacités 33a, 33b en série, par exemple d'une valeur de 3,9pF chacune, au lieu d'une unique capacité.

Une première simulation d'un tel oscillateur 50 à vide, pour observer son oscillation propre, donne des oscillations à fos = 1,025GHz et d'amplitude 1,6V. Ces oscillations sont centrées sur 1,21V et le courant de polarisation vaut 7,68mA pour un courant fourni de 14mA.

La synchronisation différentielle sur la fréquence fondamentale de l'oscillateur à injection 50 à résistance négative nécessite l'application d'impulsions, délivrées par le générateur d'impulsions 40, aux noeuds 29a, 29b du circuit résonnant. Dans ce générateur d'impulsions 40 aucune armature n'est reliée à la masse. Pour contourner cette difficulté, on utilise les deux sources de courant 23a, 23b entre les noeuds 39a, 39b de chaque côté des capacités 33a, 33b, de même amplitude, de même fréquence mais en opposition de phase.

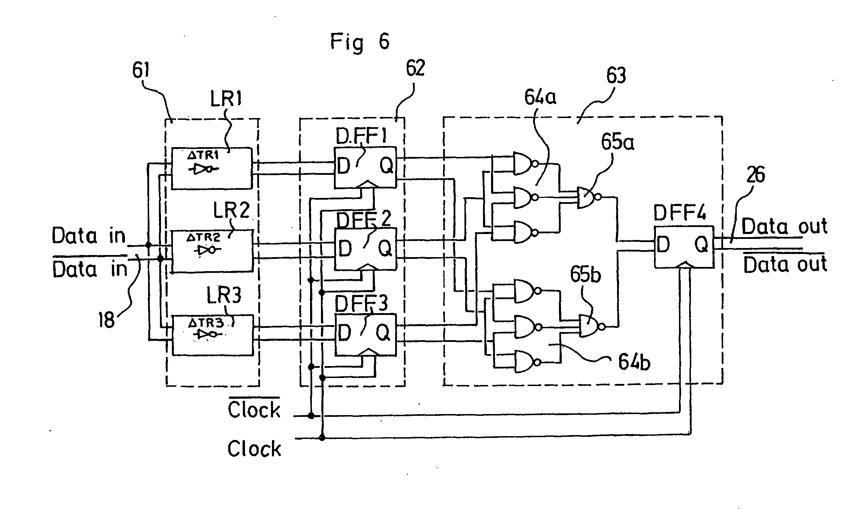

Le principe général du générateur d'impulsions 40 utilise le temps de propagation Δt d'un opérateur logique élémentaire comprenant par exemple au moins une porte NON 21 pour générer un retard. A partir du signal DATA IN reçu sur son entrée (point A), ce circuit logique 22 fournit en sortie un signal retard (point B). Ce signal retard (point B) est appliqué sur une entrée d'une porte NON-OU 22 (NOR), le signal série 18 DATA IN initial étant directement appliqué sur l'autre entrée de cette porte NON-OU 22. A la sortie C de la porte NON-OU 22, des impulsions en tension sont générées, de largeur correspondant au temps de Δt à travers la porte NON 21. Ainsi (figure 5), chaque fois que le changement d'état '0' vers '1' intervient, des impulsions de tension ayant le même rythme que le signal série 18 DATA IN sont générées. Le signal A figure 5 est la composante DATA IN du signal série 18 amplifié arrivant à l'entrée (point A) du générateur d'impulsions 40. Le signal B figure 5 est celui obtenu à la sortie de la porte NON 21. Le signal C est le signal d'impulsions obtenu au point C, figure 4.

Pour obtenir des impulsions de courant, les deux sources de courant 23a, 23b sont placées en parallèle à la sortie de la porte NON-1 OU 22. L'une 23a des sources de courant fournit des impulsions positives. L'autre source de courant 23b fournit des impulsions négatives.

Pour avoir une plage de synchronisation suffisante, il faut calculer l'amplitude et la largeur d'impulsions en courant nécessaires. Les inventeurs ont déterminé que malgré le fait que les impulsions ne sont pas périodiques, avec un tel circuit, lorsque les impulsions en courant ont une largeur légèrement inférieure à la moitié d'une période du signal de sortie de l'oscillateur 50, la plage de synchronisation est optimale et donnée par :

$$\Delta f = 2 \frac{|\ \text{Isync}\ |}{|\ \text{V0}\ |} \sqrt{F_g^2 + F_x^2} \qquad [2]$$

avec :

- Fg et Fx sont les coefficients d'élasticité de fréquence, représentant la sensibilité de la fréquence de sortie de l'oscillateur 50 par rapport respectivement à la partie réelle et à la partie imaginaire du circuit résonnant,
- V0 est l'amplitude de la tension aux bornes du générateur d'impulsions 40 au repos,
- Isync est la valeur moyenne du courant de synchronisation.

La plage de synchronisation est proportionnelle à Isync. Ce paramètre physique peut être réglé pour avoir la plage nécessaire.

Rien n'empêche de prévoir un ajustement grossier de fos par calibration sur le circuit intégré. Néanmoins, le circuit de l'invention assure, en fait par construction, un accrochage en fréquence sur une très large plage.

Les essais effectués sur des prototypes du circuit ont démontré que l'oscillateur à injection 50 est capable de restituer une horloge dès lors que le taux de transitions de bits du signal reçu est suffisant.

Les figures 3 et 6 représentent par ailleurs le circuit de décision 24 permettant de restituer des données série numériques pures DATA OUT, DATA OUT à partir du signal série reçu amplifié 18 DATA IN, DATA IN et du signal d'horloge bits de réception 20 CLOCK, CLOCK extrait de ce signal reçu 18 par le circuit 19. Les composantes DATA IN, DATA IN sont fournies à un circuit à retards distincts 61 qui alimente un circuit à bascules D 62. Ce dernier reçoit aussi les composantes CLOCK, CLOCK du signal d'horloge bits de réception et fournit des données numériques séries à une logique de décision 63 qui délivre les données séries numériques pures DATA OUT, DATA OUT parfaitement synchronisées sur l'horloge de réception CLOCK, $\overline{\text{CLOCK}}$ et donc au moins sensiblement synchronisées sur le signal reçu DATA IN, $\overline{\text{DATA IN}}$.

Le circuit à retards distincts 61 comprend un nombre NR supérieur à 2 -notamment impair-, égal à trois dans l'exemple représenté, de lignes retard LR1, LR2, LR3 recevant chacune le signal DATA IN, DATA IN, et générant des signaux correspondant à ce signal mais retardés d'une valeur fixe prédéterminée $\Delta$TR1, $\Delta$TR2, $\Delta$TR3 inférieure à Tn, où Tn est la période de la fréquence nominale fn. Une de ces valeurs $\Delta$TR2 est de préférence égale à Tn/2, les autres étant réparties symétriquement autour de cette valeur centrale.

Chaque ligne retard LR1, LR2, LR3 est formée d'une ou plusieurs portes logiques, par exemple des portes NON, fournissant un retard de phase prédéterminé.

Les trois retards $\Delta$TR1, $\Delta$TR2, $\Delta$TR3 délivrés par les lignes retard LR1, LR2, LR3 sont distincts. Chacun d'entre eux est par exemple un multiple d'une fraction entière prédéterminée, inférieure ou égale à Tn/(NR+1), de la période nominale Tn. La valeur Tn/(NR+1) est préférentielle. Par exemple avec NR=3, on choisit

$$\Delta TR1 = Tn/4$$

$$\Delta TR2 = 2\ Tn/4$$

$$\Delta TR3 = 3\ Tn/4$$

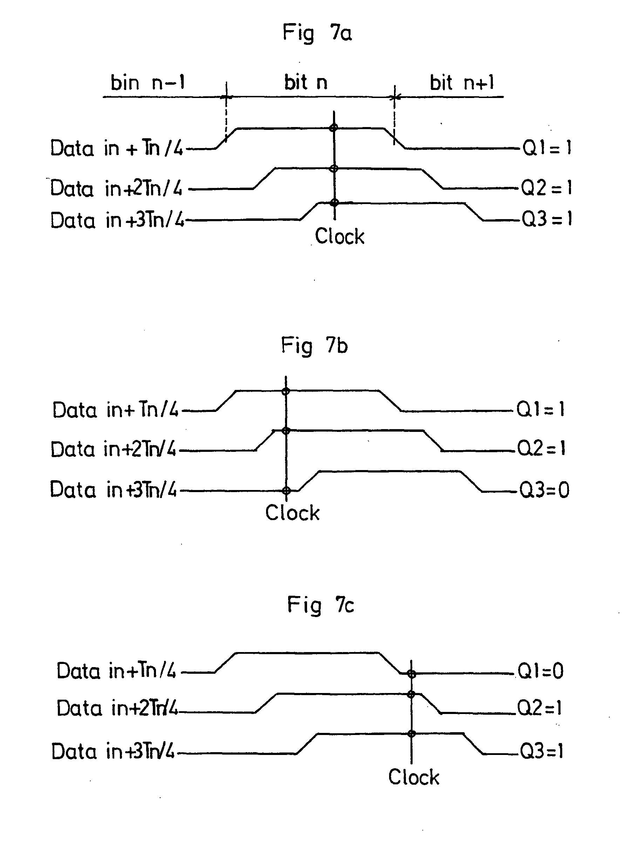

Avec ces valeurs, la trame fournie par la deuxième ligne retard LR2 est théoriquement en phase avec le front descendant de l'horloge de réception (représenté par CLOCK figures 7a, 7b, 7c). Le circuit à bascules D 62 comprend NR bascules D distinctes DFF1, DFF2, DFF3 recevant respectivement les signaux issus des NR lignes retards LR1, LR2, LR3, ainsi que le signal d'horloge de réception CLOCK, CLOCK. Ces bascules D échantillonnent le signal qu'elles reçoivent sur leurs entrées D pour fournir sur leurs sorties Q des données numériques pures synchronisées sur l'horloge de réception CLOCK, $\overline{\text{CLOCK}}$.

Les figures 7a, 7b, 7c donnent trois exemples de signaux reçus (une seule composante est représentée sur ces figures) en entrée par les trois bascules DFF1, DFF2, DFF3, et indiquent les valeurs des sorties Q1, Q2, Q3 respectives données par ces bascules selon la phase relative du signal de réception CLOCK par rapport au signal reçu DATA IN. Il se peut en effet qu'une légère dérive de phase se produise dans le signal d'horloge de réception CLOCK, CLOCK fourni par l'oscillateur synchrone 50.

Dans le cas de la figure 7a, le signal d'horloge de réception CLOCK est approximativement en phase avec le signal DATA IN. Les trois bascules fournissent la même valeur Q1 = Q2 = Q3, égale à 1 dans l'exemple représenté.

Dans le cas de la figure 7b, le signal d'horloge CLOCK présente une légère dérive en retard sur le signal DATA IN, l'une des bascules DFF3 fournissant une valeur erronée Q3=0, tandis que les deux autres DFF1, DFF2 fournissent une valeur correcte Q1=Q2=1.

Dans le cas de la figure 7c, le signal d'horloge CLOCK présente une légère dérive en avance sur le signal DATA IN, l'une des bascules DFF1 fournissant une valeur erronée Q1=0, tandis que les deux autres DFF2, DFF3 fournissent une valeur correcte Q2=Q3=1.

Dans le cas des figures 7b, 7c, une information de dérive de phase peut être fournie par un circuit logique (non représenté) et ensuite exploitée par le système.

La logique de décision 63 permet aussi de fournir en tant que données numériques séries DATA OUT, DATA OUT , la valeur donnée en majorité par les différentes NR bascules DFF1, DFF2, DFF3 du circuit à bascules 62, et ce, nonobstant la présence d'une impulsion parasite dans le signal reçu qui modifierait la valeur de l'une des sorties Q1, Q2, Q3. Cette logique de décision 63 comprend, pour chaque composante du signal, un premier étage de trois portes NON-ET (NAND) 64a, 64b dont les sorties alimentent une nouvelle porte NON-ET 65a, 65b, alimentant une entrée d'une bascule DFF4 qui échantillonne à nouveau les données sur le signal CLOCK, CLOCK pour fournir sur ses sorties Q le signal de données numériques série 26 DATA OUT, DATA OUT parfaitement synchronisées sur le signal CLOCK, CLOCK.

Un circuit intégré monolithique a été réalisé sur une technologie HCMOS7 ($0,25\mu$m) du fondeur STMicroelectronics (Grenoble, France). Ce circuit VLSI est réalisé en technologie CMOS sans couche spécifique analogique. Ce circuit intégré incorporait le générateur d'impulsions et l'oscillateur à injection 50. Les composants occupant le plus de place sur le circuit sont les inductances 32a, 32b de l'oscillateur 50. Il se trouve que leur dimension, avec une telle intégration, correspond à une fréquence fos élevée, qui dans l'exemple était de l'ordre de 1GHz.

Les résultats suivants ont été obtenus

- l'oscillateur 50 reste accroché sur un signal PRBS31 (séquence binaire aléatoire d'ordre 31) avec 94 ps de dérive de phase (crête à crête) et 11,0 ps de moyenne quadratique (RMS) de dérive de phase ;
- avec un signal PRBS7 (séquence binaire aléatoire d'ordre 7), on obtient une dérive de phase de 60 ps (crête à crête) et un écart type de la dérive de phase de 9,8 ps en moyenne quadratique (RMS).

Le circuit de décision 24 peut être réalisé sur le même circuit intégré monolithique que le circuit de récupération d'horloge 19. Un tel circuit a été réalisé sur une technologie HCMOS8d ($0,18 \mu$m) de STMicroeletronics. L'oscillateur à injection 50 a été réalisé avec un circuit LC de 900x750 $\mu$m$^2$. Avec ces dimensions, on obtient encore une fréquence fos de l'ordre de 1GHz. L'oscillateur 50 reste accroché sur un signal PRBS11 avec 1,49 ps de moyenne quadratique (RMS) de dérive de phase.

L'invention peut faire l'objet de nombreuses variantes de réalisation par rapport au mode de réalisation décrit et représenté à titre d'exemple non limitatif. En particulier, les polarités et fonctions logiques peuvent être modifiées et adaptées pour obtenir les mêmes résultats ; l'oscillateur à injection 50 peut être réalisé différemment, par exemple avec des transistors autres que NMOS ; le circuit de décision 24 peut comprendre NR=5 bascules D et lignes retard ou au contraire être formé d'une seule bascule D.

## Revendications

1.  - Procédé de transmission de données numériques sur une liaison série en bande de base selon une fréquence nominale fn supérieure à 500 MHz entre un émetteur (1) et un récepteur (2) reliés par un canal (5) de transmission dans lequel :

    - l'émetteur (1) émet sur le canal (5) un signal série en bande de base, dit signal émis, représentatif des données numériques à transmettre, cadencé selon une fréquence d'horloge bits correspondant à la fréquence nominale fn,
    - le récepteur (2):

        . comprend un circuit (19) de récupération d'horloge apte à générer un signal d'horloge, dit signal d'horloge de réception, au moins sensiblement synchronisé et en phase avec la fréquence d'horloge bits fsr du signal série en bande de base, dit signal reçu, que le récepteur (2) reçoit du canal (5) de transmission, ce circuit (19) de récupération d'horloge comprenant un oscillateur (50) à injection incorporé dans un circuit intégré monolithique, comprenant deux branches comprenant chacune un transistor (34a, 34b) à effet de champ à résistance négative, les deux transistors (34a, 34b) étant couplés selon une topologie différentielle, l'oscillateur (50) ayant une fréquence propre fos correspondant au moins sensiblement à la fréquence nominale fn et comportant une sortie (37a, 37b) délivrant un signal d'horloge de réception au moins sensiblement synchronisé et en phase avec la fréquence d'horloge bits fsr du signal reçu,

**caractérisé en ce qu'**on utilise dans le circuit (19) de récupération d'horloge, un générateur d'impulsions (40) délivrant un signal d'impulsions numériques à la fréquence de fronts du signal reçu, comprenant deux sources de courant (23a, 23b) adaptées pour délivrer des impulsions différentiels en opposition de phase, reliées respectivement à des noeuds (39a, 39b) d'entrées/sorties des deux branches (38a, 38b) de l'oscillateur (50).

**2.** - Procédé selon la revendication 1, **caractérisé en ce qu'**on fournit à l'oscillateur à injection (50) un signal d'impulsions représentatif d'une seule catégorie de fronts choisie parmi la catégorie des fronts montants et la catégorie des fronts descendants, et synchronisé avec cette catégorie de fronts du signal reçu.

**3.** - Procédé selon l'une des revendications 1 ou 2, **caractérisé en ce que** le générateur d'impulsions (40) et l'oscillateur (50) à injection sont adaptés pour que la largeur des impulsions en courant délivrées par le générateur d'impulsions (40), soit de l'ordre de la moitié de la période correspondant à la fréquence propre fos de l'oscillateur (50) à injection.

**4.** - Procédé selon l'une des revendications 1 à 3, **caractérisé en ce que** le générateur d'impulsions (40) et l'oscillateur (50) à injection sont adaptés pour que la largeur des impulsions en courant délivrées par le générateur d'impulsions (40), soit inférieure à la moitié de la période correspondant à la fréquence propre fos de l'oscillateur (50) à injection.

**5.** - Procédé selon l'une des revendications 1 à 4, **caractérisé en ce qu'**on utilise un circuit intégré monolithique formant le circuit (19) de récupération d'horloge incorporant le générateur d'impulsions (40) et l'oscillateur à injection (50).

**6.** - Procédé selon l'une des revendications 1 à 5, **caractérisé en ce que** les deux branches (38a, 38b) de l'oscillateur à injection (50) sont symétriques, parallèles et comprennent chacune un transistor (34a, 34b) à effet de champ, une inductance série (32a, 32b) et une capacité (33a, 33b) parallèle.

**7.** - Procédé selon la revendication 6, **caractérisé en ce que** dans chaque branche (38a, 38b) l'inductance (32a, 32b) est reliée au transistor (34a, 34b) par le noeud (39a, 39b) d'entrée/sortie relié à une source de courant du générateur d'impulsions (40).

**8.** - Procédé selon l'une des revendications 6 ou 7, **caractérisé en ce que** les deux branches (38a, 38b) sont alimentées par une source de tension (31) commune reliée à chaque inductance (32a, 32b) et par une source de courant (35) commune reliée entre des premières bornes des transistors (34a, 34b) et le potentiel le plus faible, l'inductance (32a, 32b) et la capacité (33a, 33b) de chaque branche (38a, 38b) étant reliées à une deuxième borne du transistor (34a, 34b), qui est aussi reliée à la grille du transistor (34b, 34a) de l'autre branche (38b, 38a).

**9.** - Procédé selon l'une des revendications 1 à 8, **caractérisé en ce que** les deux sources de courant (23a, 23b) du générateur d'impulsions (40) sont montées en parallèle et adaptées pour délivrer des signaux de même amplitude et de même fréquence.

**10.** - Procédé selon l'une des revendications 1 à 9, **caractérisé en ce que** le récepteur (2) comprend un circuit de décision (24) recevant le signal d'horloge de réception et le signal reçu et comprenant un nombre au moins égal à 3, de bascules D fournissant des données décalées selon des durées de décalage distinctes par rapport aux impulsions de signal d'horloge de réception, mais normalement incluses dans la période de la fréquence nominale fn.

**11.** - Dispositif de transmission de données numériques sur une liaison série en bande de base selon une fréquence nominale supérieure fn à 500 MHz entre un émetteur (1) et un récepteur (2) reliés par un canal (5) de transmission dans lequel :

- l'émetteur (1) est adapté pour émettre sur le canal (5) un signal série en bande de base, dit signal émis, représentatif des données numériques à transmettre, cadencé selon une fréquence d'horloge bits correspondant à la fréquence nominale fn,
- le récepteur (2) :

. comprend un circuit (19) de récupération d'horloge apte à générer un signal d'horloge, dit signal d'horloge de réception, au moins sensiblement synchronisé et en phase avec la fréquence d'horloge bits fsr du signal série en bande de base, dit signal reçu, que le récepteur (2) reçoit du canal (5) de transmission, ce circuit (19) de récupération d'horloge comprenant un oscillateur (50) à injection incorporé dans un circuit intégré monolithique, comprenant deux branches comprenant chacune un transistor (34a, 34b) à effet de champ à résistance négative, les deux transistors (34a, 34b) étant couplés selon une topologie différentielle, cet oscillateur (50) ayant une fréquence propre fos correspondant au moins sensiblement à la fréquence nominale fn et comportant une sortie (37a, 37b) délivrant un signal d'horloge de réception au moins sensiblement synchronisé et en phase avec la fréquence d'horloge bits fsr du signal reçu,

**caractérisé en ce que** le circuit (19) de récupération d'horloge comprend un générateur d'impulsions (40) délivrant un signal d'impulsions numériques à la fréquence de fronts du signal reçu, comprenant deux sources de courant (23a, 23b) adaptées pour délivrer des impulsions différentiels en opposition de phase, reliées respectivement à des noeuds (39a, 39b) d'entrées/sorties des deux branches (38a, 38b) de l'oscillateur (50).

**12.** - Dispositif selon la revendication 11, **caractérisé en ce que** le générateur d'impulsions (40) est adapté pour fournir à l'oscillateur à injection (50) un signal d'impulsions représentatif d'une seule catégorie de fronts choisie parmi la catégorie des fronts montants et la catégorie des fronts descendants, et synchronisé avec cette catégorie de fronts du signal reçu.

**13.** - Dispositif selon l'une des revendications 11 ou 12, **caractérisé en ce que** le générateur d'impulsions (40) et l'oscillateur (50) à injection sont adaptés pour que la largeur des impulsions en courant délivrées par le générateur d'impulsions (40), soit de l'ordre de la moitié de la période correspondant à la fréquence propre fos de l'oscillateur (50) à injection.

**14.** - Dispositif selon l'une des revendications 11 à 13, **caractérisé en ce que** le générateur d'impulsions (40) et l'oscillateur (50) à injection sont adaptés pour que la largeur des impulsions en courant délivrées par le générateur d'impulsions (40), soit inférieure à la moitié de la période correspondant à la fréquence propre fos de l'oscillateur (50) à injection.

**15.** - Dispositif selon l'une des revendications 11 à 14, **caractérisé en ce que** le circuit (19) de récupération d'horloge est formé sur un circuit intégré monolithique incorporant le générateur d'impulsions (40) et l'oscillateur à injection (50).

**16.** - Dispositif selon l'une des revendications 11 à 15, **caractérisé en ce que** les deux branches (38a, 38b) de l'oscillateur à injection (50) sont symétriques, parallèles, et comprennent chacune un transistor (34a, 34b) à effet de champ, une inductance série (32a, 32b) et une capacité (33a, 33b) parallèle.

**17.** - Dispositif selon la revendication 16, **caractérisé en ce que** dans chaque branche (38a, 38b) l'inductance (32a, 32b) est reliée au transistor (34a, 34b) par le noeud (39a, 39b) d'entrée/sortie relié à une source de courant du générateur d'impulsions (40).

**18.** - Dispositif selon l'une des revendications 16 ou 17, **caractérisé en ce** les deux branches (38a, 38b) sont alimentées par une source de tension (31) commune reliée à chaque inductance (32a, 32b) et par une source de courant (35) commune reliée entre des premières bornes des transistors (34a, 34b) et le potentiel le plus faible, l'inductance (32a, 32b) et la capacité (33a, 33b) de chaque branche (38a, 38b) étant reliées à une deuxième borne du transistor (34a, 34b), qui est aussi reliée à la grille du transistor (34b, 34a) de l'autre branche (38b, 38a).

**19.** - Dispositif selon l'une des revendications 11 à 18, **caractérisé en ce que** les deux sources de courant (23a, 23b) du générateur d'impulsions (40) sont montées en parallèle et adaptées pour délivrer des signaux de même amplitude et de même fréquence.

**20.** - Dispositif selon l'une des revendications 11 à 19, **caractérisé en ce** le récepteur (2) comprend un circuit de décision (24) recevant le signal d'horloge de réception et le signal reçu et comprenant un nombre au moins égal à 3, de bascules D fournissant des données décalées selon des durées de décalage distinctes par rapport aux impulsions du signal d'horloge de réception, mais normalement incluses dans la période de la fréquence nominale fn.

**Claims**

1. Method of transmitting digital data on a serial baseband link according to a nominal frequency fn greater than 500 MHz between a transmitter (1) and a receiver (2) which are linked by a transmission channel (5), wherein:

   - the transmitter (1) emits on the channel (5) a serial baseband signal, called the emitted signal, representing the digital data to be transmitted, at a rate according to a bit clock frequency fsr corresponding to the nominal frequency fn,
   - the receiver (2):

     . includes a clock recovery circuit (19) which is suitable for generating a clock signal, called the reception clock signal, which is at least approximately synchronised and in phase with the bit clock frequency fsr of the serial baseband signal, called the received signal, which the receiver (2) receives from the transmission channel (5), this clock recovery circuit (19) including an injection oscillator (50) which is incorporated in a monolithic integrated circuit, including two branches each including a field effect transistor (34a, 34b) with negative resistance, the two transistors (34a, 34b) being coupled according to a differential topology, the oscillator (50) having a natural frequency fos corresponding at least approximately to the nominal frequency fn, and including an output (37a, 37b) supplying a reception clock signal which is at least substantially synchronised and in phase with the bit clock frequency fsr of the received signal,

   **characterized in that** in the clock recovery circuit (19), a pulse generator (40) is used, supplying a digital pulse signal at the edge frequency of the received signal, including two current sources (23a, 23b) which are suitable for supplying differential opposite phase pulses and connected respectively to input/output nodes (39a, 39b) of the two branches (38a, 38b) of the oscillator (50).

2. Method according to Claim 1, **characterized in that** a pulse signal representing a single category of edges chosen from the category of rising edges and the category of falling edges, and synchronised with this category of edges of the received signal, is supplied to the injection oscillator (50).

3. Method according to one of Claims 1 or 2, **characterized in that** the pulse generator (40) and injection oscillator (50) are matched so that the width of the current pulses which the pulse generator (40) supplies is of the order of half the period corresponding to the natural frequency fos of the injection oscillator (50).

4. Method according to one of Claims 1 to 3, **characterized in that** the pulse generator (40) and injection oscillator (50) are matched so that the width of the current pulses which the pulse generator (40) supplies is less than half the period corresponding to the natural frequency fos of the injection oscillator (50).

5. Method according to one of Claims 1 to 4, **characterized in that** a monolithic integrated circuit, forming the clock recovery circuit (19) which incorporates the pulse generator (40) and injection oscillator (50), is used.

6. Method according to one of Claims 1 to 5, **characterized in that** the two branches (38a, 38b) of the injection oscillator (50) are symmetrical and parallel, and each include a field effect transistor (34a, 34b), a series inductor (32a, 32b) and a parallel capacitor (33a, 33b).

7. Method according to Claim 6, **characterized in that** in each branch (38a, 38b), the inductor (32a, 32b) is connected to the transistor (34a, 34b) via the input/output node (39a, 39b), which is connected to a current source of the pulse generator (40).

8. Method according to one of Claims 6 or 7, **characterized in that** the two branches (38a, 38b) are fed by a common voltage source (31) which is connected to each inductor (32a, 32b), and by a common current source (35) which is connected between the first terminals of the transistors (34a, 34b) and the weaker potential, the inductor (32a, 32b) and capacitor (33a, 33b) of each branch (38a, 38b) being connected to a second terminal of the transistor (34a, 34b), which is also connected to the gate of the transistor (34a, 34b) of the other branch (38a, 38b).

9. Method according to one of Claims 1 to 8, **characterized in that** the two current sources (23a, 23b) of the pulse generator (40) are fitted in parallel and suitable for supplying signals of the same amplitude and same frequency.

10. Method according to one of Claims 1 to 9, **characterized in that** the receiver (2) includes a decision circuit (24) which receives the reception clock signal and the received signal, said decision circuit (24) including a number at least equal to 3 of flip-flops D which supply shifted data according to shift durations which are distinct in relation to the reception clock signal pulses, but usually included in the period of the nominal frequency fn.

11. Device for transmitting digital data on a serial baseband link according to a nominal frequency fn greater than 500 MHz between a transmitter (1) and a receiver (2) which are linked by a transmission channel (5), wherein:

- the transmitter (1) is suitable for emitting on the channel (5) a serial baseband signal, called the emitted signal, representing the digital data to be transmitted, at a rate according to a bit clock frequency corresponding to the nominal frequency fn,
- the receiver (2):

  . includes a clock recovery circuit (19) which is suitable for generating a clock signal, called the reception clock signal, which is at least approximately synchronised and in phase with the bit clock frequency fsr of the serial baseband signal, called the received signal, which the receiver (2) receives from the transmission channel (5), this clock recovery circuit (19) including an injection oscillator (50) which is incorporated in a monolithic integrated circuit, including two branches each including a field effect transistor (34a, 34b) with negative resistance, the two transistors (34a, 34b) being coupled according to a differential topology, this oscillator (50) having a natural frequency fos corresponding at least approximately to the nominal frequency fn, and including an output (37a, 37b) supplying a reception clock signal which is at least approximately synchronised and in phase with the bit clock frequency fsr of the received signal,

  **characterized in that** the clock recovery circuit (19) includes a pulse generator (40), supplying a digital pulse signal at the edge frequency of the received signal, including two current sources (23a, 23b) which are suitable for supplying differential opposite phase pulses and connected respectively to input/output nodes (39a, 39b) of the two branches (38a, 38b) of the oscillator (50).

12. Device according to Claim 11, **characterized in that** the pulse generator (40) is suitable for supplying a pulse signal representing a single category of edges chosen from the category of rising edges and the category of falling edges, and synchronised with this category of edges of the received signal, to the injection oscillator (50).

13. Device according to one of Claims 11 or 12, **characterized in that** the pulse generator (40) and injection oscillator (50) are matched so that the width of the current pulses which the pulse generator (40) supplies is of the order of half the period corresponding to the natural frequency fos of the injection oscillator (50).

14. Device according to one of Claims 11 to 13, **characterized in that** the pulse generator (40) and injection oscillator (50) are matched so that the width of the current pulses which the pulse generator (40) supplies is less than half the period corresponding to the natural frequency fos of the injection oscillator (50).

15. Device according to one of Claims 11 to 14, **characterized in that** the clock recovery circuit (19) is formed on a monolithic integrated circuit which incorporates the pulse generator (40) and injection oscillator (50).

16. Device according to one of Claims. 11 to 15, **characterized in that** the two branches (38a, 38b) of the injection oscillator (50) are symmetrical and parallel, and each include a field effect transistor (34a, 34b), a series inductor (32a, 32b) and a parallel capacitor (33a, 33b).

17. Device according to Claim 16, **characterized in that** in each branch (38a, 38b), the inductor (32a, 32b) is connected to the transistor (34a, 34b) via the input/output node (39a, 39b), which is connected to a current source of the pulse generator (40).

18. Device according to one of Claims 16 or 17, **characterized in that** the two branches (38a, 38b) are fed by a common voltage source (31) which is connected to each inductor (32a, 32b), and by a common current source (35) which is connected between the first terminals of the transistors (34a, 34b) and the weaker potential, the inductor (32a, 32b) and capacitor (33a, 33b) of each branch (38a, 38b) being connected to a second terminal of the transistor (34a, 34b), which is also connected to the gate of the transistor (34a, 34b) of the other branch (38a, 38b).

19. Device according to one of Claims 11 to 18, **characterized in that** the two current sources (23a, 23b) of the pulse generator (40) are fitted in parallel and suitable for supplying signals of the same amplitude and same frequency.

20. Device according to one of Claims 11 to 19, **characterized in that** the receiver (2) includes a decision circuit (24) which receives the reception clock signal and the received signal, said decision circuit (24) including a number at least equal to 3 of flip-flops D which supply shifted data according to shift durations which are distinct in relation to the reception clock signal pulses, but usually included in the period of the nominal frequency fn.

**Patentansprüche**

1. - Verfahren zur Übertragung von Digitaldaten auf einer seriellen Verbindung im Basisband mit einer Nennfrequenz fn von über 500 MHz zwischen einem Sender (1) und einem Empfänger (2), die durch einen Datenübertragungskanal (5) verbunden sind, bei dem:

   - Der Sender (1) auf dem Kanal (5) ein serielles Signal im Basisband sendet, das sogenannte gesendete Signal, das für die zu übertragenden Digitaldaten repräsentativ ist und gemäß einer Bit-Taktfrequenz fsr getaktet ist, die der Nennfrequenz fn entspricht;
   - Der Empfänger (2):

   . einen Taktrückgewinnungskreis (19) umfaßt, der geeignet ist, ein Taktsignal, ein sogenanntes Empfangstaktsignal, zu generieren, das zumindest deutlich synchronisiert und in Phase mit der Bit-Taktfrequenz fsr des seriellen Signals im Basisband, dem sogenannten empfangenen Signal, ist, das der Empfänger (2) vom Übertragungskanal (5) erhält, wobei dieser Taktrückgewinnungskreis (19) einen Einspeisungs-Oszillator (50) umfaßt, der in einen monolithischen integrierten Schaltkreis eingebunden ist, der zwei Zweige umfaßt, die jeweils einen Feldeffekt-Transistor (34a, 34b) mit Negativwiderstand umfassen, wobei die beiden Transistoren (34a, 34b) nach einer Differentialtopologie gekoppelt sind, wobei der Oszillator (50) eine Eigenfrequenz fos hat, die zumindest deutlich der Nennfrequenz fn entspricht und einen Ausgang (37a, 37b) umfaßt, der ein Empfangstaktsignal abgibt, das zumindest deutlich synchronisiert und in Phase mit der Bit-Taktferquenz fsr des empfangenen Signals ist,

   **dadurch gekennzeichnet, daß** im Taktrückgewinnungskreis (19) ein Impulsgenerator (40) eingesetzt wird, der ein Signal mit Digitalimpulsen mit der Frequenz von Flanken des empfangenen Signals abgibt, der zwei Stromquellen (23a, 23b) umfaßt, die geeignet sind, Differentialimpulse im Phasengegensatz abzugeben, die jeweils mit Knotenpunkten (39a, 39b) für Eingänge/Ausgänge der beiden Zweige (38a, 38b) des Oszillators (50) verbunden sind.

2. - Verfahren nach Anspruch 1, **dadurch gekennzeichnet, daß** dem Einspeisungs-Oszillator (50) ein Impulssignal geliefert wird, das repräsentativ für eine einzige Kategorie von Flanken ist, die unter der Kategorie der ansteigenden Flanken und der Kategorie der absteigenden Flanken gewählt wird und mit dieser Kategorie der Flanken des empfangenen Signals synchronisiert ist.

3. - Verfahren nach einem beliebigen der vorstehenden Ansprüche 1 oder 2, **dadurch gekennzeichnet, daß** der Impulsgenerator (40) und der Einspeisungs-Oszillator (50) geeignet sind, damit die Breite der vom Impulsgenerator (40) abgegebenen Stromimpulse in Höhe der Hälfte der Periode beträgt, die der Eigenfrequenz fos des Einspeisungs-Oszillators (50) entspricht.

4. - Verfahren nach einem beliebigen der vorstehenden Ansprüche 1 bis 3, **dadurch gekennzeichnet, daß** der Impulsgenerator (40) und der Einspeisungs-Oszillator (50) geeignet sind, damit die Breite der vom Impulsgenerator (40) abgegebenen Stromimpulse unter der Hälfte der Periode beträgt, die der Eigenfrequenz fos des Einspeisungs-Oszillators (50) entspricht.

5. - Verfahren nach einem beliebigen der vorstehenden Ansprüche 1 bis 4, **dadurch gekennzeichnet, daß** ein monolithischer integrierter Schaltkreis eingesetzt wird, der den Taktrückgewinnungskreis (19) bildet, der den Impulsgenerator (40) und den Einspeisungs-Oszillator (50) einschließt.

6. - Verfahren nach einem beliebigen der vorstehenden Ansprüche 1 bis 5, **dadurch gekennzeichnet, daß** die beiden Zweige (38a, 38b) des Einspeisungs-Oszillators (50) symmetrisch und parallel sind und jeweils einen Feldeffekttransistor (34a, 34b), eine Serieninduktivität (32a, 32b) und eine parallele Kapazität (33a, 33b) umfassen.

7. - Verfahren nach Anspruch 6, **dadurch gekennzeichnet, daß** in jedem Zweig (38a, 38b) die Induktivität (32a, 32b) durch den Eingangs-/Ausgangs-Knotenpunkt (39a, 39b) mit dem Transistor (34a, 34b) verbunden ist, der mit einer Stromquelle des Impulsgenerators (40) verbunden ist.

8. - Verfahren nach einem beliebigen der vorstehenden Ansprüche 6 oder 7, **dadurch gekennzeichnet, daß** die beiden Zweige (38a, 38b) von einer gemeinsamen Spannungsquelle (31) gespeist werden, die mit jeder Induktivität (32a, 32b) verbunden ist, und von einer gemeinsamen Stromquelle (35), die zwischen ersten Klemmen der Transistoren (34a, 34b) und dem schwächsten Potential verbunden ist, wobei die Induktivität (32a, 32b) und die Kapazität (33a, 33b) jedes Zweigs (38a, 38b) mit einer zweiten Klemme des Transistors (34a, 34b) verbunden sind, die auch mit der Steuerelektrode des Transistors (34a, 34b) des anderen Zweigs (38b, 38a) verbunden ist.

9. - Verfahren nach einem beliebigen der vorstehenden Ansprüche 1 bis 8, **dadurch gekennzeichnet, daß** die beiden Stromquellen (23a, 23b) des Impulsgenerators (40) parallel montiert und geeignet sind, Signale mit der gleichen Amplitude und der gleichen Frequenz abzugeben.

10. - Verfahren nach einem beliebigen der vorstehenden Ansprüche 1 bis 9, **dadurch gekennzeichnet, daß** der Empfänger (2) eine Entscheidungsschaltüng (24) umfaßt, die das Empfangstaktsignal und das empfangene Signal erhält und eine Anzahl von zumindest gleich 3 Kippschaltungen D umfaßt, die die Daten liefern, die nach im Verhältnis zu den Impulsen des Empfangstaktsignals getrennten Verschiebungsdauern verschoben, jedoch normalerweise in der Periode der Nennfrequenz fn inbegriffen sind.

11. - Vorrichtung zur Übertragung von Digitaldaten auf einer seriellen Verbindung im Basisband mit einer Nennfrequenz fn von über 500 MHz zwischen einem Sender (1) und einem Empfänger (2), die durch einen Datenübertragungskanal (5) verbunden sind, bei dem:

- Der Sender (1) geeignet ist, auf dem Kanal (5) ein serielles Signal im Basisband zu senden, das sogenannte gesendete Signal, das für die zu übertragenden Digitaldaten repräsentativ ist und gemäß einer Bit-Taktfrequenz fsr getaktet ist, die der Nennfrequenz fn entspricht;
- Der Empfänger (2):

. Umfaßt einen Taktrückgewinnungskreis (19), der geeignet ist, ein Taktsignal, ein sogenanntes Empfangstaktsignal, zu generieren, das zumindest deutlich synchronisiert und in Phase mit der Bit-Taktfrequenz fsr des seriellen Signals im Basisband, dem sogenannten empfangenen Signal, ist, das der Empfänger (2) vom Übertragungskanal (5) erhält, wobei der Taktrückgewinnungskreis (19) einen Einspeisungs-Oszillator (50) umfaßt, der in einen monolithischen integrierten Schaltkreis eingebunden ist, der zwei Zweige umfaßt, die jeweils einen Feldeffekt-Transistor (34a, 34b) mit Negativwiderstand umfassen, wobei die beiden Transistoren (34a, 34b) nach einer Differentialtopologie gekoppelt sind, wobei der Oszillator (50) eine Eigenfrequenz fos hat, die zumindest deutlich der Nennfrequenz fn entspricht und einen Ausgang (37a, 37b) umfaßt, der ein Empfangstaktsignal abgibt, das zumindest deutlich synchronisiert und in Phase mit der Bit-Taktferquenz fsr des empfangenen Signals ist,

**dadurch gekennzeichnet, daß** der Taktrückgewinnungskreis (19) einen Impulsgenerator (40) umfasst, der ein Signal mit Digitalimpulsen mit der Frequenz von Flanken des empfangenen Signals abgibt, der zwei Stromquellen (23a, 23b) umfaßt, die geeignet sind, Differentialimpulse im Phasengegensatz abzugeben, die jeweils mit Knotenpunkten (39a, 39b) für Eingänge/Ausgänge der beiden Zweige (38a, 38b) des Oszillators (50) verbunden sind.

12. - Verfahren nach Anspruch 11, **dadurch gekennzeichnet, daß** der Impulsgenerator (40) geeignet ist, dem Einspeisungs-Oszillator (50) ein Impulssignal zu liefern, das repräsentativ für eine einzige Kategorie von Flanken ist, die unter der Kategorie der ansteigenden Flanken und der Kategorie der absteigenden Flanken gewählt wird und mit dieser Kategorie der Flanken des empfangenen Signals synchronisiert ist.

13. - Verfahren nach einem beliebigen der vorstehenden Ansprüche 11 oder 12, **dadurch gekennzeichnet, daß** der Impulsgenerator (40) und der Einspeipungs-Oszillator (50) geeignet sind, damit die Breite der vom Impulsgenerator (40) abgegebenen Stromimpulse in Höhe der Hälfte der Periode beträgt, die der Eigenfrequenz fos des Einspeisungs-Oszillators (50) entspricht.

14. - Verfahren nach einem beliebigen der vorstehenden Ansprüche 11 bis 13, **dadurch gekennzeichnet, daß** der Impulsgenerator (40) und der Einspeisungs-Oszillator (50) geeignet sind, damit die Breite der vom Impulsgenerator (40) abgegebenen Stromimpulse unter der Hälfte der Periode beträgt, die der Eigenfrequenz fos des Einspeisungs-Oszillators (50) entspricht.

**15.** - Verfahren nach einem beliebigen der vorstehenden Ansprüche 11 bis 14, **dadurch gekennzeichnet, daß** der Taktrückgewinnungskreis (19) auf einem monolithischen integrierten Schaltkreis gebildet wird, der den Impulsgenerator (40) und den Einspeisungs-Oszillator (50) einschließt.

**16.** - Verfahren nach einem beliebigen der vorstehenden Ansprüche 11 bis 15, **dadurch gekennzeichnet, daß** die beiden Zweige (38a, 38b) des Einspeisungs-Oszillators (50) symmetrisch und parallel sind und jeweils einen Feldeffekttransistor; (34a, 34b), eine Serieninduktivität (32a, 32b) und eine parallele Kapazität (33a, 33b) umfassen.

**17.** - Verfahren nach Anspruch 16, **dadurch gekennzeichnet, daß** in jedem Zweig (38a, 38b) die Induktivität (32a, 32b) durch den Eingangs-/Ausgangs-Knotenpunkt (39a, 39b) mit dem Transistor (34a, 34b) verbunden ist, der mit einer Stromquelle des Impulsgenerators (40) verbunden ist.

**18.** - Verfahren nach einem beliebigen der vorstehenden Ansprüche 16 oder 17, **dadurch gekennzeichnet, daß** die beiden Zweige (38a, 38b) von einer gemeinsamen Spannungsquelle (31) gespeist werden, die mit jeder Induktivität (32a, 32b) verbunden ist, und von einer gemeinsamen Stromquelle (35), die zwischen ersten Klemmen der Transistoren (34a, 34b) und dem schwächsten Potential verbunden ist, wobei die Induktivität (32a, 32b) und die Kapazität (33a, 33b) jedes Zweigs (38a, 38b) mit einer zweiten Klemme des Transistors (34a, 34b) verbunden sind, die auch mit der Steuerelektrode des Transistors (34a,34b) des anderen Zweigs (38b, 38a) verbunden ist.

**19.** - Verfahren nach einem beliebigen der vorstehenden Ansprüche 11 bis 18, **dadurch gekennzeichnet, daß** die beiden Stromquellen (23a, 23b) des Impulsgenerators (40) parallel montiert und geeignet sind, Signale mit der gleichen Amplitude und der gleichen Frequenz abzugeben.

**20.** - Verfahren nach einem beliebigen der vorstehenden Ansprüche 11 bis 19, **dadurch gekennzeichnet, daß** der Empfänger (2) eine Entscheidungsschaltung (24) umfaßt, die das Empfangstaktsignal und das empfangene Signal erhält und eine Anzahl von zumindest gleich 3 Kippschaltungen D umfaßt, die die Daten liefern, die nach im Verhältnis zu den Impulsen des Empfangstaktsignals getrennten Verschiebungsdauern verschoben, jedoch normalerweise in der Periode der Nennfrequenz fn inbegriffen sind.

Fig 1

Fig 2

Fig 3

Fig 4

Fig 5

Fig 6

## Fig 7a

| bin n-1 | bit n | bit n+1 |

Data in + Tn/4 ——————————— Q1 = 1

Data in +2Tn/4 ——————————— Q2 = 1

Data in +3Tn/4 ——————————— Q3 = 1

Clock

## Fig 7b

Data in+ Tn/4 ——————————— Q1 = 1

Data in+2Tn/4 ——————————— Q2 = 1

Data in +3Tn/4 ——————————— Q3 = 0

Clock

## Fig 7c

Data in+Tn/4 ——————————— Q1 = 0

Data in+2Tn/4 ——————————— Q2 = 1

Data in+3Tn/4 ——————————— Q3 = 1

Clock

## RÉFÉRENCES CITÉES DANS LA DESCRIPTION

**Documents brevets cités dans la description**

- US 6256361 B

- US 6317008 B

**Littérature non-brevet citée dans la description**

- **C. SCHEYTT et al.** A 0.155, 0.622-, and 2.488-Gb/s Automatic Bit-Rate Selecting dock and Data Recovery IC for Bit-Rate Transparent SDH Systems. *IEEE Journal of Solid State Circuits,* 12 Décembre 1999, vol. 34
- **H. DJAHANSHAHI et al.** Differential CMOS circuits for 622-MHz/933-MHz Clock and Data Recovery Applications. *IEEE Journal of Solid State Circuits,* Juin 2000, vol. 35 (6

- **T.H. LEE et al.** A 155MHz Clock Recovery Delay-and Phase-Locked Loop. *IEEE Journal of Solid State Circuits,* Décembre 1992, vol. 27 (12
- **X.5. YAO ; G. LUTES.** A High-Speed Photonic dock and Carrier Regenerator. *TDA Progress report,* 15 Mai 1995, 202-210